# EUROPÄISCHE PATENTANMELDUNG

(11) **EP 4 192 200 A1**
(43) Veröffentlichungstag der Anmeldung: **07.06.2023**
(21) Anmeldenummer: 21211558.8
(22) Anmeldetag: 01.12.2021
(51) Int. Cl.: H05K 1/02, H05K 1/18

(54) **LEITERPLATTE, VERFAHREN ZU SEINER HERSTELLUNG, SOWIE VERWENDUNG IN EINER WERKZEUGMASCHINE**

(71) Anmelder: Hilti Aktiengesellschaft, 9494 Schaan (LI)
(72) Erfinder: Lacher, Michael, 86830 Schwabmünchen (DE)
(74) Vertreter: Hilti Aktiengesellschaft Corporate Intellectual Property

(57) **Zusammenfassung**

Die vorliegende Erfindung betrifft eine Leiterplatte mit mindestens einem ersten elektronischen Bauteil und einem zweiten elektronischen Bauteil. Mindestens ein elektronisches Bauteil liegt auf einer Vorderseite der Leiterplatte vor, während mindestens ein anderes elektronisches Bauteil auf einer Rückseite der Leiterplatte angeordnet vorliegt. Bei den elektronischen Bauteilen kann es sich insbesondere um Leistungshalbleiter handeln. Es ist im Sinne der Erfindung bevorzugt, dass die elektronischen Bauteile mit Anschlüssen an der Leiterplatte befestigt werden. Die Anschlüsse können auf der Leiterplatte so zueinander versetzt vorliegen, dass eine maximale Überdeckung der zu verbindenden Anschlüsse bewirkt wird. Das bedeutet im Sinne der Erfindung bevorzugt, dass zusammengehörende Pins übereinander angeordnet werden. In weiteren Aspekten betrifft die Erfindung eine Verwendung einer Leiterplatte in einer Handwerkzeugmaschine, sowie ein Verfahren zur Herstellung einer vorgeschlagenen Leiterplatte. Mit der Erfindung kann ein Flächenbedarf für die Bestückung der Leiterplatte mit elektronischen Bauteilen, wie Leistungshalbleitern, reduziert und eine gute Kühlung der Bauteile ermöglicht werden.

## Beschreibung

Die vorliegende Erfindung betrifft eine Leiterplatte mit mindestens einem ersten elektronischen Bauteil und einem zweiten elektronischen Bauteil. Mindestens ein elektronisches Bauteil liegt auf einer Vorderseite der Leiterplatte vor, während mindestens ein anderes elektronisches Bauteil auf einer Rückseite der Leiterplatte angeordnet vorliegt. Bei den elektronischen Bauteilen kann es sich insbesondere um Leistungshalbleiter handeln. Es ist im Sinne der Erfindung bevorzugt, dass die elektronischen Bauteile mit Anschlüssen an der Leiterplatte befestigt werden. Darüber hinaus können die Anschlüsse auf der Leiterplatte so zueinander versetzt vorliegen, dass eine maximale Überdeckung der zu verbindenden Anschlüsse bewirkt wird. Vorzugsweise weist die Leiterplatte Pins (Kontaktstifte) und/oder Pads (Lötaugen) zur Befestigung der elektronischen Bauteile auf, wobei zusammengehörende Pins oder Pads der elektronischen Bauteile bzw. der Leistungshalbleiter vorzugsweise übereinander angeordnet werden. In weiteren Aspekten betrifft die Erfindung eine Verwendung einer Leiterplatte in einer Handwerkzeugmaschine, sowie ein Verfahren zur Herstellung einer vorgeschlagenen Leiterplatte. Mit der Erfindung kann ein Flächenbedarf für die Bestückung der Leiterplatte mit elektronischen Bauteilen, wie Leistungshalbleitern, reduziert und eine gute Kühlung der Bauteile ermöglicht werden.

### Hintergrund der Erfindung:

Die Erfindung ist auf dem technischen Gebiet der Leiterplatten (printed circuit boards, PCB) angesiedelt. Dort sind verschiedene Technologie-Ansätze bekannt, um elektrotechnische Bauteile, wie Leistungshalbleiter oder anderen Funktionsträger, auf einer Leiterplatte zu befestigen.

Beispielsweise ist im Stand der Technik die Durchsteckmontage bekannt, die aufgrund ihrer englischen Bezeichnung «through-hole technology» als THT-Verfahren bezeichnet wird. Darüber hinaus ist das «pin-in-hole»-Verfahren bekannt (PIH), bei dem es um das Einbringungen von Kontaktstiften (pins) in eine Leiterplatte geht. Die genannten Verfahren beschreiben Aufbauund Verbindungstechnologien, sowie eine Montageweise für sog. «bedrahtete Bauelemente». Darüber hinaus ist im Stand der Technik die Verwendung von oberflächenmontierten Bauelementen bekannt, wobei solche Bauelemente im Englischen als surface-mounted devices (SMD) bezeichnet werden.

Ein wichtiger Aspekt im technischen Gebiet der Leiterplatten ist die Kühlung der elektronischen Bauteile, die an der Leiterplatte befestigt sind. Es wird in diesem Zusammenhang auch von einer «Entwärmung» gesprochen. Bei der Entwärmung einer Leiterplatte kann unterschiedlich vorgegangen werden, je nachdem wie die Leiterplatte mit elektronischen Bauelementen bestückt ist.

Leistungshalbleiter können beispielsweise auf der Unter- oder Rückseite einer Leiterplatte angeordnet vorliegen. Diese Unter- oder Rückseite einer Leiterplatte wird in der Fachsprache auch als bottom bezeichnet. Auf der anderen Seite der Leiterplatte, also auf der Vorder- oder Oberseite («top») der Leiterplatte, kann eine Wärmesenke vorgesehen sein, die dazu eingerichtet ist, die bei der Verwendung der Leiterplatte bzw. seiner Komponenten entstehende Wärme abzuführen. Die Wärmesenke wird im Sinne der Erfindung bevorzugt auch als Kühlkörper bezeichnet. Bei einem anderen Konzept zur Bestückung einer Leiterplatte liegen die Leistungshalbleiter und die Kühlkörper auf derselben Seite der Leiterplatte angeordnet vor.

Nachteilig an den aus dem Stand der Technik bekannten Verfahren zur Bestückung und Entwärmung von Leiterplatten ist, dass die elektronischen Bauteile einen hohen Flächenbedarf haben, wobei der Flächenbedarf insbesondere von der Gehäuseabmessung der elektronischen Bauteile bestimmt wird. Das bedeutet, dass die Fläche einer Leiterplatte einen unteren Grenzwert nicht unterschreiten kann, wobei dieser untere Grenzwert von den Gehäuseabmessung der elektronischen Bauteile bestimmt wird. Bei Vorsehung von mehreren elektronischen Bauteilen können parasitäre Effekte auftreten, die sich durch den räumlichen Unterschied bzw. den Abstand der elektronischen Bauteile ergeben. Diese kapazitiven oder induktiven parasitären Effekte lassen sich häufig nicht unter die Gehäuseabmessung reduzieren und können negative Auswirkungen beispielsweise in der elektromagnetischen Verträglichkeit (EMV) einer Schaltung zeigen, wobei der Begriff der EMV im Kontext der vorliegenden Erfindung sowohl Störaussendung, als auch Störempfindlichkeit umfasst.

Wenn ein Leistungspfad in einem mittleren Bereich der Leiterplatte angebunden werden soll, führt dies bei Platzierung des Leistungshalbleiter auf der Vorderseite der Leiterplatte häufig zu einem zusätzlichen Flächenverlust auf der Rückseite der Leiterplatte. Darüber hinaus kann ein komplexer, aufwändiger Aufbau der Leiterplatte die Folge sein, der auch das Herstellungsverfahren der Leiterplatte kompliziert und kostenintensiv macht.

Die Aufgabe, die der vorliegenden Erfindung zugrunde liegt, besteht darin, die vorstehend beschriebenen Mängel und Nachteile des Standes der Technik zu überwinden und eine Leiterplatte und ein Herstellungsverfahren für eine Leiterplatte bereitzustellen, mit denen der Flächenbedarf für Bauelemente, die auf der Leiterplatte befestigt werden sollen, reduziert werden kann bzw. der Flächenbedarf für Bauelemente optimiert werden kann. Ein weiteres Anliegen der Erfindung ist es, eine Leistungsführung innerhalb der Leiterplatte zu ermöglichen. Die Fachwelt würde es insbesondere begrüßen, wenn auch besonders kleine Bauteile leicht und unkompliziert auf der Leiterplatte befestigt werden könnten.

Die Aufgabe wird gelöst durch den Gegenstand der unabhängigen Ansprüche. Vorteilhafte Ausführungsformen zu dem Gegenstand der unabhängigen Ansprüche finden sich in den abhängigen Ansprüchen.

### Beschreibung der Erfindung:

Erfindungsgemäß ist eine Leiterplatte vorgesehen, wobei die Leiterplatte mindestens ein erstes elektronisches Bauteil und mindestens ein zweites elektronisches Bauteil aufweist. Mindestens ein elektronisches Bauteil liegt auf einer Vorderseite der Leiterplatte vor, während mindestens ein anderes elektronischen Bauteil auf einer Rückseite der Leiterplatte angeordnet vorliegt. Es ist im Sinne der Erfindung ganz besonders bevorzugt, dass es sich bei den elektronischen Bauteilen um Leistungshalbleiter handelt. Dabei handelt es sich im Sinne der Erfindung bevorzugt um Halbleiterbauelemente, die in der Leistungselektronik für das Steuern und Schalten hoher elektrischer Ströme und/oder Spannungen ausgelegt sind. Leistungshalbleiter können beispielsweise Ströme von mehr als 20 Ampere und Spannungen von mehr als 18 Volt leiten. Eine Leiterplatte ist im Sinne der Erfindung ein Träger für elektronische Bauteile. Sie dient der mechanischen Befestigung und elektrischen Verbindung von elektronischen Bauteilen und Funktionsträgern.

Bei der Erfindung werden die unterschiedlichen Anordnungen von elektronischen Bauteilen auf einer Leiterplatte, wie sie aus dem Stand der Technik bekannt sind, besonders effizient auf elektronische Bauteile, wie zum Beispiel Leistungshalbleiter, angewendet, um eine synergistische Gesamtwirkung zu erreichen. Insbesondere werden die bekannten Top- oder Bottom-Anbringungen der elektronischen Bauteile auf einer Leiterplatte so miteinander kombiniert, dass elektronische Bauteile sowohl auf der Vorderseite, als auch auf der Rückseite der Leiterplatte vorgesehen sind. Die synergistische Gesamtwirkung wird insbesondere dadurch erreicht, dass eines der mindestens zwei elektronischen Bauteile auf der einen Seite der Leiterplatte angeordnet vorliegt, beispielsweise auf der Vorderseite, während das andere der mindestens zwei elektronischen Bauteile auf der anderen Seite der Leiterplatte angeordnet vorliegt, beispielsweise auf der Rückseite der Leiterplatte. Die synergistische Gesamtwirkung führt insbesondere zu einer deutlichen Verringerung des Flächenbedarfs, um die elektronischen Bauteile auf der Leiterplatte zu befestigen. Mit anderen Worten kann die benötigte Leiterplatten(ober)fläche durch die Erfindung erheblich reduziert werden.

Durch die erfindungsgemäße Anordnung der elektronischen Bauteile sowohl auf der Vorderseite, als auch auf der Rückseite der Leiterplatte wendet sich die Erfindung von der allgemeinen technischen Entwicklung im Bereich der Leiterplatten ab, die in die Richtung geht, dass versucht wird, elektronische Bauteile, wie (Leistungs-)Halbleiter, direkt in die Leiterplatte zu integrieren. Mit der Erfindung wird es insbesondere ermöglicht, besonders kompakte Schaltungen mit kurzen Leiterbahnen bereitzustellen.

Außerdem kann mit der vorgeschlagenen Anordnung der elektronischen Bauteile auf den gegenüberliegenden Seiten der Leiterplatte eine Leistungsführung in der Leiterplatte ermöglicht werden. Vorzugsweise bildet sich in der Leiterplatte ein Leistungspfad bzw. Leistungsfluss aus. Es ist im Sinne der Erfindung bevorzugt, dass mit jedem elektronischen Bauteil in einem Leistungspfad ein Wechsel einer Seite der Leiterplatte einhergeht.

Die Leiterplatte umfasst vorzugsweise eine Reihe von Lagen auf, insbesondere innere Lagen und äußere Lagen, wie Vorderseite (top) und Rückseite (bottom) der Leiterplatte. Einzelne dieser Lagen können Kupfer umfassen oder aus Kupfer gebildet bzw. hergestellt sein. Die Leiterplatten können aus unterschiedlichen Lagen zusammengesetzt sein. Beispielsweise können obere und untere Abschlusslagen vorgesehen sein, die die Leiterplatte nach oben bzw. nach unten gegenüber der Umwelt abschließen. Diese Abschlusslagen können beispielsweise aus Kupfer hergestellt sein, Kupfer umfassen oder einzelne kupferhaltige Bereiche («Kupferbereiche») aufweisen. Eine Leistungsführung zwischen der Vorderseite und der Rückseite der Leiterplatte erfolgt vorzugsweise in diesen Kupferlagen, die bevorzugt in einem mittleren Bereich der Leiterplatte angeordnet vorliegen. Es ist im Sinne der Erfindung bevorzugt, dass diese vorzugsweise in der Mitte der Leiterplatte angeordneten Kupferlagen im Vergleich zu anderen Komponenten bzw. Lagen der Leiterplatte dicker ausgebildet sind. Darüber hinaus können im Inneren der Leiterplatten innere Funktionslagen vorgesehen sein, die ebenfalls aus Kupfer hergestellt werden, Kupfer umfassen oder einzelne kupferhaltige Bereiche aufweisen können. Kupfer wird insbesondere wegen seiner guten elektrischen und/oder thermischen Leitfähigkeit als Material für die leitfähigen Bestandteile der Leiterplatte ausgewählt. Durch die Leistungsführung in der Leiterplatte kann eine Stärke des Kupfers bzw. der Kupferschichte in der Leiterplatte auf die Stromführung optimiert werden. Das heißt, dass die Kupferstärke in Abhängigkeit von der gewünschten Leistungsführung ausgewählt werden kann. Dafür können insbesondere dickere Kupferlagen vorgesehen sein. Zur Verbesserung der Stromtragfähigkeit können auch zwei oder mehrere Innenlagen elektrisch parallelgeschaltet werden. Die Kupferstärke der beiden Aussenlagen «Top» und «Bottom» sind dagegen vorteilhafterweise so realisiert, dass auch die Bestückung von besonders kleinen SMD-Bauteilen möglich ist. Dies wird insbesondere dadurch ermöglicht, dass die Aussenlagen «Top» und «Bottom», d.h. die äußeren Lagen der Leiterplatte, eine Stärke von kleiner oder gleich 70 µm aufweisen. Als «kleine Bauteile» werden im Sinne der Erfindung beispielsweise surface-mounted devices-Bauteile (SMD-Bauteile) der Gehäusegröße 0402 oder kleiner bezeichnet, die vorzugsweise auf einer Oberfläche der Leiterplatte angeordnet werden. Vorzugsweise können diese kleinen SMD-Bauteile auf die Oberfläche der Leiterplatte aufgelötet werden. Es ist in diesem Zusammenhang insbesondere bevorzugt, die äußeren und/ oder inneren Lagen der Leiterplatten bzw. die Stärke ihrer Kupferplatten («Kupferstärke») entsprechend auszuwählen. Es ist im Sinne der Erfindung bevorzugt, dass die äußeren Lagen der Leiterplatte eine Stärke von kleiner oder gleich 70 µm aufweisen. Die inneren Lagen der Leiterplatte weisen bevorzugt eine Stärke von größer oder gleich 70 µm auf.

Zwischen den Funktionslagen und den Kupferlagen können Lagen aus einem isolierenden Grundmaterial der Leiterplatte angeordnet sein. Zur Herstellung dieser isolierenden Lagen kann beispielsweise Harz und/oder Glasfaser verwendet werden, ohne darauf beschränkt zu sein.

Vorteilhafterweise kann die Leistungsführung insbesondere in den stärksten Innenlagen der vorgeschlagenen Leiterplatte erfolgen. In diesen stärksten inneren Kupferlagen der Leiterplatte kann eine Stärke der Kupferplatte beispielsweise bei 70 µm und mehr liegen. Tests haben gezeigt, dass bei erhöhtem Kupferbedarf weitere Lagen der Leiterplatte miteinander kombiniert werden können. Ein Vorteil der Erfindung besteht darin, dass die Kombination der Lagen ohne weitere, d.h. zusätzliche Via-Bohrungen erfolgen kann. Via-Bohrungen verlaufen vorzugsweise durch die gesamte Leiterplatte, d.h. vorzugsweise durch alle Schichten und/oder Lagen einer Leiterplatte. Via-Bohrungen sind vorzugsweise dazu eingerichtet, elektronische Bauteile der Leiterplatte miteinander zu verbinden. Sie können darüber hinaus aber auch dazu verwendet werden, Innenlagen der Leiterplatte miteinander zu verbinden. Mit anderen Worten können elektronische Bauteile und/oder einzelne Lagen, beispielsweise innenliegende Lagen, der Leiterplatte durch Via-Bohrungen miteinander verbunden werden.

Mit Hilfe der Erfindung kann die Kupferstärke einzelner Lagen beispielsweise verdoppelt werden, was sich positiv auf die Fähigkeit der Leiterplatte zur Leistungsführung auswirken kann. Dieser Vorteil kann insbesondere erreicht werden, ohne die notwendigen Abstände der Leiterbahnen bei der Herstellung der Leiterbahnstruktur zu erhöhen. Die Herstellung der Leiterplatten bzw. der Leiterbahnen umfasst häufig Ätz-Verfahrensschritte, wobei das Ätzen dazu führt, dass zwischen den einzelnen Leiterbahnen der Leiterplatte Mindestabstände nicht unterschritten werden können. Insofern war es überraschend, dass mit der Erfindung die Kupferstärke einzelner Lagen der Leiterplatte verdoppelt werden kann, ohne dass die notwendigen Abstände der Leiterbahnen bei der Herstellung der Leiterbahnstruktur erhöht werden müssen. Auf diese Weise kann eine bessere Strom- bzw. Leistungsführung erreicht werden, ohne die Herstellung der vorgeschlagenen Leiterplatte aufwändiger und/oder kostenintensiver zu gestalten.

Insbesondere ermöglicht die Erfindung und die vorgeschlagene Anordnung der elektronischen Bauteile auf den beiden Seiten der Leiterplatte eine erhebliche Reduzierung des Flächenbedarfs, so dass die vorgeschlagene Leiterplatte besonders gut in kleinen, kompakten technischen Geräten, wie beispielsweise Werkzeugmaschinen, insbesondere Handwerkzeugmaschinen, eingesetzt werden kann. Durch Verwendung der vorgeschlagenen Leiterplatten in Werkzeugmaschinen können die Werkzeugmaschinen besonders kompakt und handlich ausgebildet sein.

Es ist im Sinne der Erfindung bevorzugt, dass sich die Flächen auf der Vorder- und der Rückseite der Leiterplatte, auf denen die zu verbindenden Leistungshalbleiter angeordnet vorliegen, überlappen. Damit die Pads und/oder Pins der zu verbindenden Leistungshalbleiter eine maximale Überlappung der Flächen erreichen, ist es im Sinne der Erfindung bevorzugt, dass mit jedem Bauteil im Leistungsfluss die Leiterplattenseite gewechselt wird.

Überraschenderweise kann mit der Erfindung auch die parasitäre Induktivität von Halbbrücken wesentlich verringert werden. Das Schaltverhalten der elektronischen Bauteile, insbesondere der Leistungshalbleiter, kann insbesondere dadurch verbessert werden, dass die Störaussendung der elektrischen Schaltung gesenkt wird. Die vorgeschlagene Leiterplatte wird vorzugsweise in einer Elektronik einer Werkzeugmaschine verwendet, wobei die Werkzeugmaschine vorzugsweise einen Motor, sowie einen Motorinverter als leistungselektronische Schaltung aufweist. Der Motorinverter der Werkzeugmaschine kann beispielsweise drei Halbbrücken aufweisen, wobei dieser Aufbau im Sinne der Erfindung bevorzugt als «B6-Brücke» bezeichnet wird. Es ist im Sinne der Erfindung bevorzugt, dass eine Halbbrücke jeweils einen Low Side-Schalter und einen High Side-Schalter umfasst. Die Erfinder haben erkannt, dass mit der vorgeschlagenen Leiterplatte die parasitäre Induktivität dieser Halbbrücken erheblich reduziert werden kann. Dies kann vorteilhafterweise dadurch erreicht werden, dass die vorgeschlagene Leiterplatte in der Elektronik einer Werkzeugmaschine verwendet wird. Dadurch kann die Einsatzfähigkeit der vorgeschlagenen Leiterplatte in Werkzeugmaschinen wesentlich verbessert werden.

Es ist im Sinne der Erfindung bevorzugt, dass die elektronischen Bauteile auf der Vorderund/oder auf der Rückseite der vorgeschlagenen Leiterplatte eine Halbbrücke mit Shunt bilden.

Es ist im Sinne der Erfindung darüber hinaus bevorzugt, dass die Leistungshalbleiter des Motorinverters in einer Reihe angeordnet sind.

Es ist im Sinne der Erfindung ganz besonders bevorzugt, dass die elektronischen Bauteile auf den unterschiedlichen Seiten der Leiterplatte über Via-Bohrungen miteinander verbunden vorliegen, wobei die Via-Bohrungen insbesondere der thermischen und elektrischen Anbindung der elektronischen Bauteile dienen. Vorzugsweise weist die Leiterplatte Via-Bohrungen auf, wobei die Via-Bohrungen dazu eingerichtet sind, die elektronischen Bauteile miteinander zu verbinden. Es ist im Sinne der Erfindung ganz besonders bevorzugt, dass die Vias oder Via-Bohrungen die Leistungshalbleitern miteinander verbinden, die auf den unterschiedlichen Seiten der Leiterplatte angeordnet vorliegen. Bei den Verbindungen, die von den Vias gebildet werden, kann es sich beispielsweise um eine thermische und/oder eine elektrische Verbindung handeln. Die Vias zur thermischen Anbindung des Leistungshalbleiters an den Kühlkörper können beispielsweise durch die gesamte Leiterplatte durchgängig gestaltet sein oder mitten in der Leiterplatte aufhören *(blind via).* Die Vias können im Sinne der Erfindung bevorzugt auch als thermische Vias oder thermische Via-Bohrungen bezeichnet werden. Als Vias oder Via-Bohrungen werden vorzugsweise durchkontaktierte Bohrungen bezeichnet, die meist zur Verbindung einzelner Lagen innerhalb einer Leiterplatte verwendet werden. Vias werden in der Fachsprache bevorzugt auch als «Durchsteiger» bezeichnet. Im Sinne der Erfindung handelt es sich bevorzugt um Bohrungen durch die Leiterplatte, wobei innerhalb der Bohrungen Kupferwände vorgesehen sein können, die eine thermische und elektrische Anbindung des Leistungshalbleiters untereinander und/oder an den Kühlkörper ermöglichen.

Durch die Vorsehung der Vias kann eine besonders flächenoptimierte und kompakte Leiterplatte bereitgestellt werden. Insbesondere kann durch die Erfindung der Platz sowohl auf der Vorderseite, als auch auf der Rückseite der Leiterplatte verwendet werden, um elektronische Bauteile oder andere Funktionsträger auf der Leiterplatte zu befestigen. Dieser Platzspar-Effekt wird insbesondere durch durchgehende Via-Bohrungen erreicht, die vorzugsweise vollständig, d.h. durchgängig, zwischen der Vorderseite und der Rückseite der Leiterplatte ausgebildet sind und auf beiden Seiten einen Leistungshalbleiter anbinden bzw. miteinander verbinden.

Es ist im Sinne der Erfindung bevorzugt, dass die elektronischen Bauteile mit Anschlüssen an der Leiterplatte befestigbar sind. Als Anschlüsse können beispielsweise Pins, Kontaktstifte, Bauteilanschlüsse und/oder footprints verwendet werden, ohne darauf beschränkt zu sein. Die Anschlüsse auf der Leiterplatte können so zueinander versetzt vorliegen, dass eine maximale Überdeckung der zu verbindenden Anschlüsse bewirkt wird. Es ist im Sinne der Erfindung bevorzugt, dass auf einer Leiterplatte unterschiedliche Anschlusstypen, wie Pins, Kontaktstifte, Bauteilanschlüsse und/oder footprints, verwendet werden, wobei die unterschiedlichen Anschlusstypen geometrisch abweichend voneinander ausgestaltet sein können. Die Anschlusstypen können beispielsweise unterschiedliche Formen, Geometrien und/oder Platzbedürfnisse aufweisen. Es ist beispielsweise möglich, dass zur thermischen und/oder elektrischen Anbindung der Leistungshalbleiter mehr Platz für die Via-Bohrungen erforderlich ist als beispielsweise für die Pads. Mit anderen Worten kann der Platzbedarf einer Via-Bohrung höher sein als für einen Leistungshalbleiter-Anschluss. Die daraus resultierende Überdeckung bzw. Überlappung der zu verbindenden Anschlüsse entspricht vorzugsweise der Ersparnis an Fläche der Leiterplatte, wobei mit der vorliegenden Erfindung überraschenderweise eine besonders große Gesamtflächenersparnis erreicht werden kann.

Es ist im Sinne der Erfindung bevorzugt, dass die Leiterplatte Pads zur Befestigung der elektronischen Bauteile aufweist, wobei zusammengehörende Pads der Leistungshalbleiter übereinander angeordnet werden. Dadurch kann vorteilhafterweise eine Überlappung der Anschlüsse erreicht werden, wobei die Überlappung der Pins im Sinne der Erfindung vorzugsweise auch als Überdeckung der Anschlüsse bezeichnet wird. Es ist im Sinne der Erfindung bevorzugt, dass Pins, footprints und/ oder Anschlüsse, die zusammengehören, übereinander angeordnet werden, um eine maximale Überlappung zu erreichen. Bei den footprints kann es sich beispielsweise um Pads handeln, handeln, die verwendet werden, um die elektronischen Bauteile an der Leiterplatte zu befestigen. Es ist im Sinne der Erfindung bevorzugt, die Begriffe «Lötauge» und «Pad» synonym zu verwenden.

Es ist im Sinne der Erfindung bevorzugt, dass insbesondere eine Kontaktierung der zueinander gehörenden Pins zueinander ausgerichtet ist. Dadurch kann vorteilhafterweise die maximale Überdeckung der zu verbindenden Anschlüsse der Leistungshalbleiter auf der vorgeschlagenen Leiterplatte und die überraschend große Gesamtflächenersparnis erreicht werden.

Es ist im Sinne der Erfindung bevorzugt, dass eine Anzahl der Via-Bohrungen in Abhängigkeit von einer zu erwartenden elektrischen Belastung der Leiterplatte ausgewählt wird. Es ist im Sinne der Erfindung insbesondere bevorzugt, dass die Anzahl der Via-Bohrungen in Abhängigkeit von einer Strombelastung der Leiterplatte ausgewählt wird. Das bedeutet im Sinne der Erfindung bevorzugt, dass beispielsweise bei einer zu erwartenden hohen Strom- oder elektrischen Belastung der Bauteile eine größere Anzahl von Via-Bohrungen vorgesehen sein kann, als wenn für die Leiterplatten lediglich kleine Ströme und kleine elektrische Belastungen erwartet werden. Es ist im Sinne der Erfindung bevorzugt, dass eine Führung des Stroms im Kontext der vorliegenden Erfindung über das Kupfer in der Leiterplatte bzw. die kupferhaltigen Lagen der Leiterplatte erfolgt.

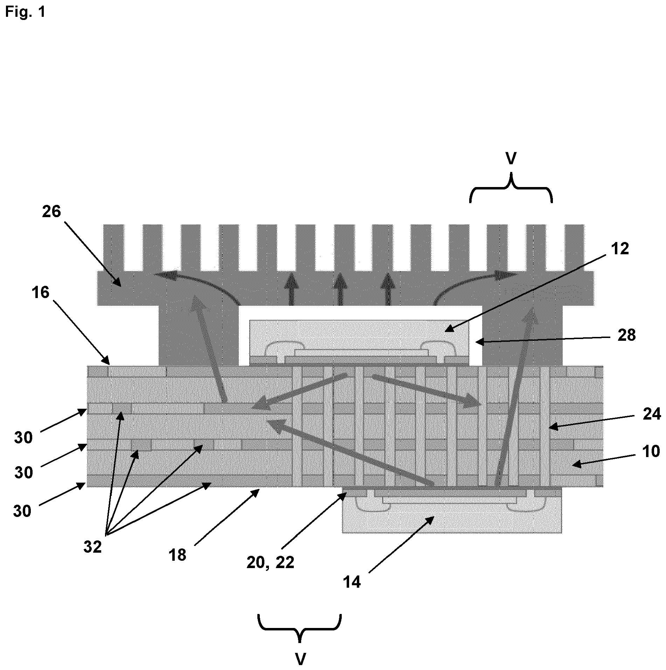

Es ist im Sinne der Erfindung bevorzugt, dass die Leiterplatte einen Kühlkörper als Wärmesenke aufweist. Vorzugsweise kann der Kühlkörper auf der Vorderseite oder auf der Rückseite der Leiterplatte angeordnet vorliegen. Es ist im Sinne der Erfindung ganz besonders bevorzugt, dass der Kühlkörper dazu eingerichtet ist, eines der elektronischen Bauteile zu umgeben. Mit anderen Worten kann der Kühlkörper eines der elektronischen Bauteile umhüllen, und zwar vorzugsweise dasjenige elektronische Bauteil, das auf derselben Seite der Leiterplatte angeordnet vorliegt wie der Kühlkörper. Dargestellt ist eine solche Situation beispielsweise in Fig. 1. Vorzugsweise ist das elektronische Bauteile mit einer seiner Außenwände an der Ober- oder Unterseite der Leiterplatte befestigt, wobei die anderen fünf Außenwände, wenn es sich um ein quaderförmiges oder im Wesentlichen quaderförmiges elektronisches Bauteil handelt, möglichst nahe an den Kühlkörper angrenzen. Es ist im Sinne der Erfindung bevorzugt, dass der Kühlkörper lediglich Kontakt zur Leiterplatte hat. Etwaige kleine Zwischenräume können mit isolierendem Wärmeleitmaterial aufgefüllt sein. Die Außenwände des elektronischen Bauteils können von einem Gehäuse gebildet werden, das im nächsten Abschnitt beschrieben wird.

Es ist im Sinne der Erfindung bevorzugt, dass die elektronischen Bauteile jeweils ein Gehäuse aufweisen, das insbesondere dazu eingerichtet ist, eine thermische Anbindung zwischen elektronischem Bauteil und Kühlkörper zu bewirken. Mit anderen Worten kann ein Wärme- bzw. Energieaustausch zwischen den elektronischen Bauteilen und dem Kühlkörper durch die Wände des Gehäuses der elektronischen Bauteile erfolgen. Der Kühlkörper kann Kühlrippen oder eine vergrößerte Oberfläche aufweisen, um die von den elektronischen Bauteilen aufgenommene Wärme schnell abzugeben bzw. weiterzuleiten. Es ist im Sinne der Erfindung bevorzugt, dass die Kühlung durch eine Luftkühlung erfolgt.

Es ist im Sinne der Erfindung bevorzugt, dass eine thermische Anbindung zwischen dem elektronischen Bauteil und dem Kühlkörper seitlich über die Leiterplatte bewirkt wird. Vorzugsweise geben die Leistungshalbleiter überschüssige Wärme in Richtung der vorgeschlagenen Leiterplatte ab, während die Leiterplatte ihre überschüssige Wärme in Richtung des Kühlkörpers abgibt. Dabei kommt die gute Wärmeleitfähigkeit des in der Leiterplatte vorhandenen Kupfers zum Tragen, welches die Entwärmung der Leiterplatte und ihrer Komponenten besonders wirksam unterstützt.

Die Wärmeflüsse innerhalb der vorgeschlagenen Leiterplatte sind beispielhaft und schematisch in Fig. 1 abgebildet. Die Wärmeflüsse werden vorzugsweise durch die Pfeile in der Figur dargestellt. Wie Fig. 1 zu entnehmen ist, kann Wärme direkt von einem elektronischen Bauteil an den Kühlkörper abgegeben werden, wobei diese Wärmeabgabe vorzugsweise über das Gehäuse des elektronischen Bauteils erfolgt. Beispielsweise kann ein erstes elektronisches Bauteil auf der Vorderseite (top) der Leiterplatte angeordnet vorliegen und seine Wärme direkt in den Kühlkörper oder in das Innere der Leiterplatte abgeben. Diese «nach innen» abgegebene Wärme des ersten elektronischen Bauteils kann vorzugsweise von den innenliegenden Kupferlagen der Leiterplatte aufgenommen werden, wobei die Kupferbestandteile der Lagen der Leiterplatte in der Figur durch einen abweichende Färbung symbolisiert werden. Indem einzelne Pfeile von dem ersten elektronischen Bauteil in diese abweichend gefärbten Bereiche der einzelnen Lagen der vorgeschlagenen Leiterplatte weisen, soll verdeutlicht werden, dass die Wärme des ersten elektronischen Bauteils in diese Kupfer-Bereiche der einzelnen Lagen der Leiterplatte geleitet werden kann. Der Pfeil, der in der linken Bildhälfte von diesem Kupferbereich in den Kühlkörper zeigt, deutet an, dass die Wärme aus den Kupferbereichen anschließend an den Kühlkörper weitergeleitet bzw. abgegeben werden kann, so dass die Wärme vorteilhafterweise von dem ersten elektronischen Bauteil über einen Kupferbereich im Inneren der Leiterplatte an den Kühlkörper abgegeben wird. Der Kühlkörper liegt in dem in Figur 1 dargestellten Ausführungsbeispiel der Erfindung auch auf der Vorderseite (top) der Leiterplatte angeordnet vor. Der Kühlkörper umgibt vorzugsweise das erste elektronische Bauteil und nimmt über das Gehäuse des ersten elektronischen Bauteils einen Teil der Wärme auf, während eine anderer Teil der Wärme des ersten elektronischen Bauteils in die Leiterplatte abgegeben wird. Fig. 1 ist auch zu entnehmen, dass der Bereich der Vorderseite der Leiterplatte, an dem das erste elektronische Bauteil angeordnet vorliegt, von Kupfer gebildet wird, um eine gute thermische Anbindung zu ermöglichen. In einem Ausführungsbeispiel der Erfindung kann der Leistungshalbleiter auf einer Oberseite (top) einer Leiterplatte angeordnet vorliegen und von dem Kühlkörper umgeben werden. Die thermische Anbindung zwischen Leistungshalbleiter und Kühlkörper kann durch ein Gehäuse des Leistungshalbleiters bewirkt werden und/oder seitlich über die Leiterplatte.

In dem in Figur 1 dargestellten Ausführungsbeispiel der Erfindung liegt ein zweites elektronisches Bauteil auf der Rückseite (bottom) der Leiterplatte vor. Auch bei diesem zweiten elektronischen Bauteil kann es sich vorzugsweise um ein Leistungshalbleiter handeln. Auch im Bereich der Rückseite der Leiterplatte ist der Bereich der äußeren Lage der Leiterplatte, an dem das zweite elektronische Bauteil angeordnet vorliegt, aus Kupfer gebildet oder umfasst Kupfer bzw. Kupfer-Bereiche. In Bezug auf die Entwärmung des zweiten elektronischen Bauteils sind in Fig. 1 zwei Möglichkeiten dargestellt. Es ist im Sinne der Erfindung bevorzugt, dass der Wärmepfad, wie oben beschrieben, vom Bauteil, beispielsweise den Leistungshalbleitern, durch die Leiterplatte zum Kühlkörper führt. Die Leiterplatte kann dabei, insbesondere über die Kupferlagen, auch verteilend auf die Wärme wirken. Diese Form der Wärmeabgabe kann vorzugsweise auch als «indirekte Entwärmung» bezeichnet werden, weil die Wärme vom zweiten elektronischen Bauteil nicht direkt an den Kühlkörper, sondern mit einer «Zwischenstation», hier der Leiterplatte, abgegeben wird.

Es ist im Sinne der Erfindung bevorzugt, dass die thermische Anbindung zwischen Leistungshalbleiter und Kühlkörper entsprechend der Lage, Position und/oder Anordnung der Leistungshalbleiter in Bezug auf den Kühlkörper erfolgt. Die thermische Anbindung kann beispielsweise seitlich oder seitlich durch die Leiterplatte erfolgen, wobei die Richtung und Form der Wärmeabgabe schematisch und beispielhaft in Fig. 1 dargestellt ist.

Es ist im Sinne der Erfindung bevorzugt, dass eine Anzahl der Via-Bohrungen in Abhängigkeit von einer gewünschten Intensität der thermischen Anbindung zwischen elektronischem Bauteil und Kühlkörper ausgewählt wird. Das bedeutet im Sinne der Erfindung bevorzugt, dass beispielsweise eine große Anzahl von Via-Bohrungen vorgesehen sein kann, wenn eine starke thermische Anbindung zwischen dem elektronischen Bauteil und dem Kühlkörper gewünscht wird, während die Anzahl der Via-Bohrungen klein gehalten werden kann, wenn die thermische Bindung zwischen dem Bauteil und dem Kühlkörper nur schwach ausgebildet sein soll.

In einem zweiten Aspekt betrifft die Erfindung eine Verwendung der vorgeschlagenen Leiterplatte in einer Handwerkzeugmaschine. Die für das Leiterplatte eingeführten Begriffe, Definitionen und technischen Vorteile gelten vorzugsweise für die Verwendung und das später vorgestellte Herstellungsverfahren für eine Leiterplatte analog. Die Verwendung der vorgeschlagenen Leiterplatte in einer Handwerkzeugmaschine hat sich als besonders vorteilhaft erwiesen, da mit der vorgeschlagenen Leiterplatte ein sehr gut zu schaltendes und kompaktes Gerät bereitgestellt werden kann. Dadurch kann der Bedienkomfort für den Nutzer erheblich gesteigert werden.

In einem weiteren Aspekt betrifft die Erfindung ein Verfahren zur Herstellung der vorgeschlagenen Leiterplatte. Mindestens ein elektronisches Bauteil liegt dabei auf einer Vorderseite der Leiterplatte vor und mindestens ein anderes elektronischen Bauteil liegt auf einer Rückseite der Leiterplatte angeordnet vor. Es ist im Kontext des vorgeschlagenen Herstellungsverfahrens bevorzugt, dass die Leistungshalbleiter mit Anschlüssen, Bauteilanschlüssen, footprints, Pads, Pins und/oder Kontaktstiften an der Leiterplatte befestigt werden kann. Alternativ oder ergänzend können die Anschlüsse auf der Leiterplatte so zueinander versetzt vorliegen, dass eine maximale Überdeckung der zu verbindenden Anschlüsse bewirkt wird. Das bedeutet im Sinne der Erfindung bevorzugt, dass die Leiterplatte Pins zur Befestigung der Leistungshalbleiter aufweist, wobei zusammengehörende Pins übereinander angeordnet werden. Der Begriff «Pin» bezeichnet im Sinne der Erfindung bevorzugt Kontaktstifte und/oder Kontaktflächen, die zur Verbindung von elektronischen Bauteilen mit einer Leiterplatte verwendet werden. Es ist im Sinne der Erfindung bevorzugt, dass die elektronischen Bauteile mit Anschlüssen an der Leiterplatte befestigt werden, wobei die Anschlüsse auf der Leiterplatte so zueinander versetzt vorliegen, dass eine maximale Überdeckung oder Überlappung der zu verbindenden Anschlüsse bewirkt wird. Der Abstand der elektronischen Bauteile, wenn die Bauteile durch eine Projektion übereinandergelegt würden, bildet einen Versatz V, der ein Maß für die Überdeckung bzw. Überlappung der Bauteile darstellt. Mit anderen Worten entspricht der Versatz V dem Abstand zwischen dem ersten und dem zweiten elektronischen Bauteil, wenn beide Bauteile gedanklich auf derselben Seite der Leiterplatte vorliegen oder gedanklich auf eine Seite der Leiterplatte projiziert würden. Mit dem Begriff «Abstand der elektronischen Bauteile» ist somit nicht der tatsächliche Abstand zwischen den Bauteilen gemeint, der sich beispielsweise durch die Dicke der Leiterplatte ergibt, sondern eine Größe zur Beschreibung einer versetzen Anordnung der elektronischen Bauteile, wobei eines der elektronischen Bauteile auf der Vorderseite der Leiterplatte angeordnet vorliegt und das zweite elektronische Bauteil auf der Rückseite der Leiterplatte vorliegt. Ein möglicher Versatz V ist in der Figur dargestellt.

Weitere Vorteile ergeben sich aus der folgenden Figurenbeschreibung. Die Figur, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

In der Figur sind gleiche und gleichartige Komponenten mit gleichen Bezugszeichen beziffert. Es zeigen:
- Fig. 1: schematische Schnittzeichnung durch eine bevorzugte Ausgestaltung der vorgeschlagenen Leiterplatte

### Ausführungsbeispiele und Figurenbeschreibung:

Figur 1 zeigt eine schematische Schnittzeichnung einer bevorzugten Ausführungsform der vorgeschlagenen Leiterplatte 10. Die Leiterplatte 10 hat eine Vorder- oder Oberseite 16, sowie eine Unter- oder Rückseite 18. Darüber hinaus kann die Leiterplatte 10 einzelne Lagen 30 umfassen, aus denen die Leiterplatte 10 aufgebaut ist. Es ist im Sinne der Erfindung bevorzugt, dass die Leiterplatte 10 eine Reihe von Lagen 30 umfasst. Diese Lagen 30, die Kupfer-Bereiche 32 aufweisen, können mit isolierenden Schichten voneinander getrennt vorliegen.

Auf der Vorderseite 16 (top) der Leiterplatte 10 ist ein erstes elektronisches Bauteil 12 angeordnet, das vorzugsweise ein Leistungshalbleiter sein kann. Auf der Rückseite 18 (bottom) der Leiterplatte 10 ist ein zweites elektronisches Bauteil 14 angeordnet, das vorzugsweise ebenfalls ein Leistungshalbleiter sein kann. In dem in Figur 1 dargestellten Ausführungsbeispiel der Erfindung weist das erste elektronische Bauteil 12 ein Gehäuse 28 auf, wobei auch das zweite elektronische Bauteil 14 ein Gehäuse 28 aufweisen kann. Es ist im Sinne der Erfindung bevorzugt, dass die Leiterplatte 10 mehr als zwei elektronische Bauteile aufweisen kann. In diesem Fall kann Fig. 1 als Ausschnitt aus einer Leiterplatte 10 mit vielen elektronischen Bauteilen aufgefasst werden.

Darüber hinaus ist auf der Vorderseite 16 (top) der Leiterplatte 10 ein Kühlkörper 26 vorgesehen, der in dem in Figur 1 dargestellten Ausführungsbeispiel der Erfindung das erste elektronische Bauteil 12 umgibt. Ein Wärmeaustausch zwischen dem elektronischen Bauteil 12 und dem Kühlkörper 26 kann insbesondere durch das Gehäuse 28 der elektronischen Bauteile 12, 14 erfolgen. Die elektronischen Bauteile 12, 14 können mit Hilfe von Anschlüssen 20 oder Pins 22 an der Leiterplatte 10 befestigt werden.

Die Leiterplatte 10 umfasst darüber hinaus Vias 24 oder Via-Bohrungen 24, die vorzugsweise durchgängig durch die Leiterplatte 10 ausgebildet sind. Die Via-Bohrungen 24 können insbesondere die elektronischen Bauteile 12, 14 miteinander verbinden. Alternativ können die Via-Bohrungen 24 auch die elektronischen Bauteile 12, 14 mit dem Kühlkörper 26 verbinden. Es ist im Sinne der Erfindung bevorzugt, dass der Bereich der Vorderseite 16 oder der Rückseite 18 der Leiterplatte 10, in dem die elektronischen Bauteile 12, 14 abgeordnet vorliegen, von Bereichen 32 gebildet werden, die Kupfer umfassen oder aus Kupfer gebildet sind. Es ist im Sinne der Erfindung bevorzugt, dass eine Teilmenge der Lagen 30 der Leiterplatte 10 Bereiche 32 aufweist, die Kupfer umfassen oder aus Kupfer gebildet sind. Diese Bereiche werden im Sinne der Erfindung bevorzugt auch als «Kupfer-Bereiche 32» bezeichnet. Die Via-Bohrungen 24 können auch Kupfer umfassen; sie können beispielsweise Kupferwände aufweisen. Durch das Kupfer in den Verbindungs-Vias 24 zwischen den elektronischen Bauteilen 12, 14 und den elektronischen Bauteilen 12, 14 und dem Kühlkörper 26 wird eine gute thermische Anbindung zwischen den genannten Komponenten 12, 14, 26 der Leiterplatte 10 erreicht.

Die Anschlüsse 20 können auf der Leiterplatte 10 so zueinander versetzt vorliegen, dass eine maximale Überdeckung der zu verbindenden Anschlüsse 20 bewirkt wird. Das bedeutet im Sinne der Erfindung bevorzugt, dass die elektronischen Bauteile 12, 14 und ihre Anschlüsse 20 so zueinander versetzt vorliegen können, dass eine optimale Entwärmung der elektronischen Bauteile 12, 14 bei gleichzeitig optimierter Strom- und/oder Leistungsführung erreicht wird.

Der Versatz zwischen den elektronischen Bauteilen 12, 14 wird in Fig. 1 mit dem Buchstaben «V» gekennzeichnet. Der Versatz V bestimmt vorzugsweise die Überdeckung bzw. die Überlappung der elektronischen Bauteile 12, 14 und führt zu der gewünschten Flächenersparnis in Bezug auf die vorgeschlagene Leiterplatte 10.

Diese optimale Entwärmung wird insbesondere dadurch erreicht, dass die elektronischen Bauteile 12, 14 optimal thermisch an den Kühlkörper 26 angebunden sind, so dass Wärme besonders leicht und unaufwändig von den elektronischen Bauteilen 12, 14 in den Bereich des Kühlkörpers 26 transportiert werden kann.

Die Wege, die die Wärme dabei nimmt, werden in Fig. 1 mit Pfeilen dargestellt. Beispielsweise kann die Wärme des ersten elektronischen Bauteils 12 über das Gehäuse 28 direkt in den Kühlkörper 26 geleitet werden. Darüber hinaus kann das erste elektronische Bauteil 12 die Wärme auch «nach unten» in das Innere der Leiterplatte 10 abgeben. Beispielsweise kann die Wärme dort von den Kupfer-Bereichen 32 der einzelnen Lagen 30 der Leiterplatte 10 aufgenommen werden, wie die zwei Pfeile andeuten, die in Fig. 1 ausgehend von dem ersten elektronischen Bauteil 12 nach unten in Richtung der Kupfer-Bereiche 32 weisen. Die Wärme wird anschließend von der Leiterplatte 10 auf den Kühlkörper 26 geleitet. Die Wärme, die von dem zweiten elektronischen Bauteil 14 abgegeben wird, kann in das Innere der Leiterplatte 10 geleitet werden und von dort weiter in Richtung des Kühlkörpers 26. Diese Form der Wärmeabgabe von einem elektronischen Bauteil 14 an den Kühlkörper 26 wird im Sinne der Erfindung als «indirekte Wärmeabgabe» bezeichnet. Eine optimale Wärmeabgabe wird insbesondere durch die maximale Überdeckung und den daraus resultierenden Versatz V der elektronischen Bauteile 12, 14 auf der Vorderseite 16 und der Rückseite 18 der Leiterplatte 10 erreicht. Der Versatz V kommt insbesondere durch eine versetzte Anordnung der elektronischen Bauteile 12, 14 zustande. Der Begriff «versetze Anordnung» ist im Sinne der Erfindung bevorzugt so zu verstehen, dass beispielsweise das erste elektronische Bauteil 12 auf der Vorderseite 16 der Leiterplatte 10 nicht an derselben Stelle angeordnet ist wie das zweite elektronische Bauteil 14 auf der Rückseite 18 der Leiterplatte 10. Der Abstand zwischen den Positionen des ersten elektronischen Bauteils 12 und des zweiten elektronischen Bauteils 14 wird im Sinne der Erfindung bevorzugt als Versatz V bezeichnet. Der Versatz V kann als Maß der Überlappung und/oder Überdeckung der elektronischen Bauteile 12, 14 auf der Leiterplatte 10 dienen und somit vorzugsweise auch für die Flächenersparnis, die sich vorteilhafterweise durch die «beidseitige» Anordnung der elektronischen Bauteile 12, 14 auf jeweils einer Seite 16, 18 der vorgeschlagenen Leiterplatte 10 ergibt.

Die Leiterplatte 10 kann Pins 22 zur Befestigung der elektronischen Bauteile 12, 14 aufweisen, wobei zusammengehörende Pins 22 übereinander angeordnet werden können. Vorzugsweise kann mit jedem elektronischen Bauteil 12, 14 in einem Leistungsfluss ein Wechsel einer Seite 16, 18 der Leiterplatte 10 einhergehen.

### Bezugszeichenliste

- 10: Leiterplatte
- 12: erstes elektronisches Bauteil
- 14: zweites elektronisches Bauteil
- 16: Vorderseite der Leiterplatte
- 18: Rückseite der Leiterplatte
- 20: Anschlüsse
- 22: Pins
- 24: Via-Bohrungen
- 26: Kühlkörper
- 28: Gehäuse der elektronischen Bauteile
- 30: Lagen innerhalb der Leiterplatte
- 32: Kupfer-Bereiche innerhalb der Lagen der Leiterplatten
- V: Versatz

## Patentansprüche

1. Leiterplatte (10) mit mindestens einem ersten elektronischen Bauteil (12) und einem zweiten elektronischen Bauteil (14)
**dadurch gekennzeichnet, dass**
mindestens ein elektronisches Bauteil (12) auf einer Vorderseite (16) der Leiterplatte (10) und mindestens ein anderes elektronischen Bauteil (14) auf einer Rückseite (18) der Leiterplatte (10) angeordnet vorliegt.

2. Leiterplatte (10) nach Anspruch 1
**dadurch gekennzeichnet, dass**
mit jedem elektronischen Bauteil (12, 14) in einem Leistungsfluss ein Wechsel einer Seite (16, 18) der Leiterplatte (10) einhergeht.

3. Leiterplatte (10) nach Anspruch 1 oder 2
**dadurch gekennzeichnet, dass**
die elektronischen Bauteile (12, 14) mit Anschlüssen (20) an der Leiterplatte (10) befestigbar sind, wobei die Anschlüsse (20) auf der Leiterplatte (10) so zueinander versetzt vorliegen, dass eine maximale Überdeckung der zu verbindenden Anschlüsse (20) bewirkt wird.

4. Leiterplatte (10) nach einem der vorhergehenden Ansprüche
**dadurch gekennzeichnet, dass**
die Leiterplatte (10) Pins (22) zur Befestigung der elektronischen Bauteile (12, 14) aufweist, wobei zusammengehörende Pins (22) übereinander angeordnet sind.

5. Leiterplatte (10) nach einem der vorhergehenden Ansprüche
**dadurch gekennzeichnet, dass**
die Leiterplatte (10) eine Reihe von Lagen (30) umfasst, wobei eine Teilmenge der Lagen (30) Bereiche (32) aufweist, die Kupfer umfassen oder aus Kupfer gebildet sind.

6. Leiterplatte (10) nach Anspruch 5
**dadurch gekennzeichnet, dass**
äußere Lagen (30) eine der Leiterplatte eine Stärke von kleiner oder gleich 70 µm aufweisen und/oder innenliegende Lagen der Leiterplatte eine Stärke von größer oder gleich 70 µm aufweisen.

7. Leiterplatte (10) nach Anspruch 5 oder 6
**dadurch gekennzeichnet, dass**
eine Leistungsführung in innenliegenden Lagen (30) der Leiterplatte (10) erfolgt.

8. Leiterplatte (10) nach einem der vorhergehenden Ansprüche
**dadurch gekennzeichnet, dass**
die Leiterplatte (10) Via-Bohrungen (24) aufweist, die die elektronischen Bauteile (12, 14) miteinander verbinden.

9. Leiterplatte (10) nach Anspruch 8
**dadurch gekennzeichnet, dass**
eine Anzahl der Via-Bohrungen (24) in Abhängigkeit von einer elektrischen Belastung ausgewählt wird.

10. Leiterplatte (10) nach einem der vorhergehenden Ansprüche
**dadurch gekennzeichnet, dass**
die Leiterplatte (10) einen Kühlkörper (26) als Wärmesenke aufweist.

11. Leiterplatte (10) nach Anspruch 10
**dadurch gekennzeichnet, dass**
der Kühlkörper (26) auf der Vorderseite (16) oder auf der Rückseite (18) der Leiterplatte (10) angeordnet vorliegt.

12. Leiterplatte (10) nach einem der Ansprüche Anspruch 10 oder 11
**dadurch gekennzeichnet, dass**
eine thermische Anbindung zwischen elektronischem Bauteil (12, 14) und Kühlkörper (26) seitlich über die Leiterplatte (10) bewirkt wird.

13. Leiterplatte (10) nach Anspruch 12
**dadurch gekennzeichnet, dass**
eine Anzahl der Via-Bohrungen (24) in Abhängigkeit von einer gewünschten Intensität der thermischen Anbindung zwischen elektronischem Bauteil (12,14) und Kühlkörper (26) ausgewählt wird.

14. Verwendung einer Leiterplatte (10) nach einem der vorhergehenden Ansprüche in einer Handwerkzeugmaschine

15. Verfahren zur Herstellung einer Leiterplatte (10) nach einem der Ansprüche 1 bis 13
**dadurch gekennzeichnet, dass**
mindestens ein elektronisches Bauteil (12) auf einer Vorderseite (16) der Leiterplatte (10) und mindestens ein anderes elektronischen Bauteil (14) auf einer Rückseite (18) der Leiterplatte (10) angeordnet vorliegt.
